(19) Europäisches Patentamt
European Patent Office
Office européen des brevets

(11) Publication number: **0 626 622 A1**

(12) **EUROPEAN PATENT APPLICATION**

(21) Application number: **93201538.1**

(22) Date of filing: **28.05.93**

(51) Int. Cl.[5]: **G03F 7/34**, G03F 7/00, B41M 5/035, G03F 3/10

(43) Date of publication of application: **30.11.94 Bulletin 94/48**

(84) Designated Contracting States: **BE DE FR GB NL**

(71) Applicant: **AGFA-GEVAERT naamloze vennootschap**
**Septestraat 27**
**B-2640 Mortsel (BE)**

(72) Inventor: **Leenders, Luc c/o Agfa-Gevaert N.V.**
**DIE 3800, Septestraat 27**
**B-2640 Mortsel (BE)**
Inventor: **Uytterhoeven, Herman c/o Agfa-Gevaert N.V.**
**DIE 3800, Septestraat 27**
**B-2640 Mortsel (BE)**

(54) **Method of making heat-transferred dye prints.**

(57) Method of making heat-transferred dye prints comprising the consecutive steps of laminating a photosensitive recording material comprising a subbed transparent support and a photopolymerizable layer onto a dye (precursor) material comprising an unsubbed support and a heat-transferable dye (precursor) layer so as to bring the photopolymerizable layer in contact with the heat-transferable dye (precursor) layer and to cause the photopolymerizable layer to adhere to the heat-transferable dye (precursor) layer, exposing the resulting laminate through the subbed transparent film support to image-wise modulated electromagnetic radiation, to which the photopolymerizable layer is sensitive, to bring about an image-like differentiation in adhesiveness of said photopolymerizable layer towards the adjacent heat-transferable dye (precursor) layer, peeling said recording material from said dye (precursor) material, heat-transferable dye (precursor) being taken away thereby from said dye (precursor) material and adhering to said recording material in correspondence with the created image-like differentiation in adhesiveness, bringing said recording material carrying a transferred dye (precursor) pattern in contact with a receptor material, and overall heating the contacting materials to allow at least part of the dye (precursor) pattern to transfer to said receptor material, causing - in the case of said dye precursor - reaction of said dye precursor on the receptor material with a reagent present in said receptor material or in a fluid medium applied thereto to convert said dye precursor into a dye.

EP 0 626 622 A1

1. Field of the invention.

The present invention relates to a method of making heat-transferred dye prints.

2. Background of the invention.

Several methods are known for transferring heat-diffusible dye from an overall heated element comprising such dye in combination with an image-wise distribution of photopolymerized areas and unpolymerized areas onto a receiving element, the photopolymerized areas inhibiting or reducing the diffusion of the dye to the receiving element.

It is for instance known from US-A 3,245,796 to use a photopolymerizable element comprising a mixture of an $\alpha,\beta$-ethylenically unsaturated compound and a sublimable dye for forming by photo-initiated addition polymerization of said $\alpha,\beta$-ethylenically unsaturated compound a mask containing insoluble areas, through which the passage of the sublimable dye is impeded, and to overall heat the mask-containing element while in contact with a receptor surface so that transfer of the sublimable dye from the non-polymerized areas to the contacting receptor surface can take place.

In US-A 4,587,198 a process has been described for providing a colour image comprising exposing a photoresist-type material comprising in the order given a support, a vapour-deposited dye or pigment layer, and a radiation-sensitive coating to an image-wise distribution of radiation that alters the solubility and/or permeability of said coating and uniformly heating said material while in contact with a receptor to evaporate said sublimable dye or pigment and deposit it on the contacting receptor.

In EP-A 362,827 an image-forming method has been described, which comprises the steps of using an image-forming medium containing a heat-diffusible colouring matter, a polymerizable polymer precursor, and a polymerization initiator, causing the polymerizable polymer precursor to image-wise polymerize, and heating the imaged medium while in contact with a receiving medium to diffusion-transfer the heat-diffusible colouring matter thereto, the heating being such as to satisfy the formula $Tg1 \leqq Ttrans \leqq Tg2$, wherein Ttrans represents the temperature of the image-forming medium, Tg1 represents the glass transition temperature of unpolymerized areas, and Tg2 the glass transition temperature of polymerized areas.

The prior art materials and methods used so far often have the disadvantage of providing an unwanted hue or fog in the background areas.

SUMMARY OF THE INVENTION

It is therefore an object of the present invention to provide an improved method of making heat-transferred dye prints.

This and other objects of the present invention are achieved by providing a method of making heat-transferred dye prints, which method comprises the following consecutive steps :

- laminating a photosensitive recording material comprising a subbed transparent synthetic resin film support and a photopolymerizable layer onto a dye or dye precursor material comprising an unsubbed synthetic resin film support and a heat-transferable dye layer or heat-transferable dye precursor layer so as to bring the photopolymerizable layer in face-to-face contact with the heat-transferable dye or dye precursor layer and to cause the photopolymerizable layer to adhere to the heat-transferable dye or dye precursor layer,
- exposing the resulting laminate through the subbed transparent synthetic resin film support to image-wise modulated electromagnetic radiation, to which the photopolymerizable layer is sensitive, to bring about an image-like differentiation in adhesiveness of said photopolymerizable layer towards the adjacent heat-transferable dye or dye precursor layer,
- peeling said recording material from said dye or dye precursor material, heat-transferable dye or dye precursor being taken away thereby from said dye or dye precursor material and adhering to said recording material in correspondence with the created image-like differentiation in adhesiveness,
- bringing said recording material carrying a transferred dye or dye precursor pattern in face-to-face contact with a receptor material,
- overall heating at least one of the contacting recording material and receptor material to a temperature sufficiently high and for a sufficient time to allow at least part of the dye or dye precursor pattern to diffuse and transfer to said receptor material, and
- causing - in the case of said dye precursor - reaction of said dye precursor on the receptor material with a reagent present in said receptor material or in a fluid medium applied to said receptor material to convert said dye precursor into a dye.

According to an alternative embodiment of the method of the present invention the said resulting laminate is heated after the exposure to image-wise modulated electromagnetic radiation to enhance said image-like differentiation in adhesiveness.

According to another alternative embodiment of the method of the present invention said recording material carrying a transferred dye or dye precursor pattern prior to being brought in face-to-face contact with a receptor material is uniformly exposed to UV-radiation to enhance said image-like differentiation in adhesiveness.

According to a further alternative embodiment of the method of the present invention the dye transferred onto the receptor material is mordanted.

DETAILED DESCRIPTION OF THE INVENTION

It may be possible to make more than one heat-transferred print from the same recording material carrying a transferred dye or dye precursor pattern by repeating the overall heating of the recording material while being brought in face-to-face contact with another receptor material.

The change in adhesiveness of the photopolymerizable layer towards the adjacent heat-transferable dye or dye precursor layer brought about during the exposure to image-wise modulated electromagnetic radiation can be either an increase in adhesiveness or alternatively a reduction in adhesiveness.

According to a first embodiment the adhesiveness of the photopolymerizable layer towards the adjacent heat-transferable dye or dye precursor layer enhances at the photopolymerized areas during the image-wise exposure to electromagnetic radiation. As a result, the adhesion of the exposed photopolymerized areas to the dye or dye precursor layer is higher than that at the unexposed unpolymerized areas and a strong cohesion is created in the exposed photopolymerized areas. This cohesion is strong enough to withstand the stress of peel-apart forces so that the exposed photopolymerized areas remain integral and as a result of the enhanced adhesion thereof to the dye or dye precursor material are capable of taking away heat-transferable dye or dye precursor therefrom.

The composition of the photopolymerizable layer is such that upon exposure to actinic radiation e.g. ultraviolet radiation, the cohesion of that layer increases e.g. through a cross-linking reaction.

Photopolymerizable layers obtaining a higher cohesion as a result of a photochemically induced crosslinking or polymerization reaction are well known to those skilled in the art. Reference can be made in this respect to e.g. "Imaging Systems" by K.I. Jacobson & R.E. Jacobson, The Focal Press, London & New York (1976) and in the Encyclopedia of Polymer Science and Technology - Supplement Vol I (1976) John Wiley & Sons Inc USA, in which a survey of photoradical-forming compounds has been given, the radicals of which are suitable for initiating a polymerization or crosslinking reaction.

Suitable photoradical-forming compounds and photopolymerizable compounds for use in the photopolymerizable layer employed in the method according to the present invention are i.a. those described in the European Patent Application N° 92200424.7 and in the corresponding US Serial N° , in the European Patent Application N° 92201716.5 and in the corresponding US Serial N° , in the European Patent Application N° 93200140.7 and in the corresponding US Serial N° , and in the German Patent Application N° 4129284.7 and in the corresponding US Serial N° , and in particular the compounds M1 to M7 listed in Table 1 of said German Patent Application N° 4129284.7 (special preference being given to compound M7), and in US 3,558,309.

Other suitable photopolymerizable compounds are e.g. divinylbenzene, diglycol diacrylates, N,N-alkylene bis-acrylamides, triethyleneglycol diacrylate, triethyleneglycol dimethacrylate, pentaerythritol triacrylate, pentaerythritol tetraacrylate, trimethylolpropane trimethacrylate, and bisphenol A diacrylate.

According to a second embodiment the adhesiveness of the photopolymerizable layer towards the adjacent heat-transferable dye or dye precursor layer is weakening at the photopolymerizing areas during image-wise exposure to electromagnetic radiation. As a result, the adhesion of the exposed photopolymerized areas to the dye or dye precursor layer is lower than that at the unexposed unpolymerized areas or at the partially unexposed unpolymerized areas. It is self-evident that during peeling off of the recording material from the dye or dye precursor material, heat-transferable dye or dye precursor will be taken away from the unexposed unpolymerized areas or in a lesser degree from the partially unexposed unpolymerized areas of the dye or dye precursor material to the extent wherein said adhesiveness has remained at these places in correspondence with the extent of photoexposure.

The photopolymerizable layer used according this second embodiment can be applied from an aqueous coating composition being a loaded polymeric latex composition comprising an aqueous continuous phase and a dispersed or discontinuous phase consisting essentially of latex polymer particles loaded with a hydrophobic photopolymerizable composition.

Details about incorporating the hydrophobic photopolymerizable composition into dispersed latex polymer particles and about the ingredients suited for forming a photopolymerizable layer for use according to the second embodiment can be found in i.a. Research Disclosure 28997 (May 1988) pages 332-335.

The subbed transparent synthetic resin film support can be any of the known transparent film supports e.g. a polyester film supports such as a polyethylene terephthalate film support, cellulose acetate film support such as a cellulose triacetate film support, or a polycarbonate film support. The transparent synthetic resin film support is provided with at least one subbing layer before the application thereto of a photopolymerizable layer or photodegradable layer.

The unsubbed synthetic resin film support can be made of polyesters such as polyethylene terephthalate, polyamides, polyacrylates, polycarbonates, polyvinyl chloride, cellulose esters, fluorinated polymers, polyethers, polyacetals, polyolefins, polyimides, glassine paper, and condenser paper. Preference is given to a support comprising polyethylene terephthalate.

The heat-transferable dye can be any dye that can be released by fusion, vapourization, or sublimation. Suitable dyes have been described in e.g. EP-A 209,990, EP-A 209,991, EP-A 216,483, EP-A 218,397, EP-A 227,095, EP-A 227,096, EP-A 229,374, EP-A 235,939, EP-A 247,737, EP-A 257,577, EP-A 257,580, EP-A 258,856, EP-A 279,330, EP-A 279,467, EP-A 285,665, US-A 4,743,582, US-A 4,753,922, US-A 4,753,923, US-A 4,757,046, US-A 4,769,360, US-A 4,771,035, JP 84/78894, JP 84/78895, JP 84/78896, JP 84/227,490, JP 84/227,948, JP 85/27594, JP 85/30391, JP 85/229,787, JP 85/229,789, JP 85/229,790, JP 85/229,791, JP 85/229,792, JP 85/229,793, JP 85/229,795, JP 86/41596, JP 86/268,493, JP 86/268,494, JP 86/268,495, and JP 86/284,489.

The heat-transferable dye precursor can be any dye precursor e.g. a leucobase dye precursor or a colour former that can be released by fusion, vapourization, or sublimation. Suitable dye precursors have been described in e.g. USP 5,030,612.

The following polymers can be used as binder for the dye or dye precursor : cellulose derivatives, such as ethyl cellulose, hydroxyethyl cellulose, ethylhydroxy cellulose, ethylhydroxyethyl cellulose, hydroxypropyl cellulose, methyl cellulose, cellulose nitrate, cellulose acetate formate, cellulose acetate hydrogen phthalate, cellulose acetate, cellulose acetate propionate, cellulose acetate butyrate, cellulose acetate pentanoate, cellulose acetate benzoate, cellulose triacetate; vinyl-type resins and derivatives, such as polyvinyl alcohol, polyvinyl acetate, polyvinyl butyral, copolyvinyl butyral-vinyl acetal-vinyl alcohol, polyvinyl pyrrolidone, polyvinyl acetoacetal, polyacrylamide; polymers and copolymers derived from acrylates and acrylate derivatives, such as polyacrylic acid, polymethyl methacrylate and styrene-acrylate copolymers; polyester resins; polycarbonates; copolystyrene-acrylonitrile; polysulfones; polyphenylene oxide; organosilicones, such as polysiloxanes; epoxy resins and natural resins, such as gum arabic. Preferably, the binder for the dye layer of the present invention comprises cellulose acetate butyrate or copolystyrene-acrylonitrile.

The heat-transferred dye may be the final image that needs no further treatment. Alternatively, the heat-transferred dye may be mordanted or fixed with the aid of mordanting agent(s).

In case the transferred image is a dye precursor image, the dye precursor is caused to react with at least one reagent present in the receptor material or in a fluid medium applied to said receptor material so as to convert the dye precursor into a dye. Optionally, the dye thus obtained may still be mordanted with the aid of mordanting agents.

The reagent used for reacting with the dye precursor may be any compound that is capable of converting said diffused dye precursor into a dye. For instance, when the diffused dye precursor is a colour former, said reagent may be an oxidized photographic developing agent e.g. a p-phenylene diamine developing agent or a derivative thereof. A dye image can then be formed as a result of the coupling reaction between the diffused dye precursor and the oxidized p-phenylene diamine developing agent. The photographic developer may be applied in the form of an aqueous alkaline bath onto the receptor material comprising the diffused dye precursor. Alternatively, the developing agent may be incorporated into the photopolymerizable layer or into a special layer provided between the subbed transparent film support and the photopolymerizable layer. In this case the transferred dye precursor is developed during the overall heating and thermal diffusion. Furthermore, it is also possible to incorporate the developing agent into the receptor material.

Many other reagents can be used for entering into reaction with the heat-transferable dye precursor to form a dye. Examples of such reagents are zinc oxide, calcium sulphate, novolac-type phenol resins, and zinc-3,5-dimethyl-tert.butyl salicylate.

The exposure of the photopolymerizable layer to image-wise modulated electromagnetic radiation can be a contact exposure using e.g ultraviolet radiation, a camera exposure, a scanning exposure, or a laser exposure. The radiation source used in carrying out the exposure step includes e.g. sunlight, incandescent

lamps, mercury vapour lamps, halogen lamps, xenon lamps, fluorescent lamps, light-emitting diodes, lasers, electron rays, and X-rays.

The heating elements used for overall heating according to the method of the present invention can be chosen from glazing elements, flat or curved heating surfaces or platens, roll laminator devices, radiant sources, and laser sources.

When the dye transfer is performed for but one single colour, a monochrome dye transfer image is obtained. A multicolour image can be obtained by using a recording material containing three or more primary colour dyes and sequentially performing the process steps described above for each colour. A black-and-white image can be obtained by using a recording material containing three or more primary colour dyes, which after performing the process steps described above together form a black-and-white image.

The method of the invention can be used for making dye images, contact proofing images, digital proofing images, ID-cards, security cards, continuous tone images, screened or halftone images, etc.

The following examples illustrate the present invention.

EXAMPLE 1

A photosensitive recording material was made by coating a subbed polyethylene terephthalate support having a thickness of 12 µm with a first subbing layer (0.13 g/m2) consisting essentially of a polyester comprising sulphonic acid groups and next with a second subbing layer (1.07 g/m2) comprising polyvinyl alcohol, at least 25 mol % of the hydroxy groups thereof having been modified with methacryloyl chloride.

The subbed surface of the support was covered with a photopolymerizable composition comprising 1.60 g/m2 of bis-imidazole, 0.05 g/m2 of Michler's ketone, 0.10 g/m2 of mercaptobenzoxazole, and 2.24 g of the photopolymerizable compound M7 listed in Table 1 of the above-mentioned German Patent Application N° 4129284.7, said compound corresponding to the following structural formula :

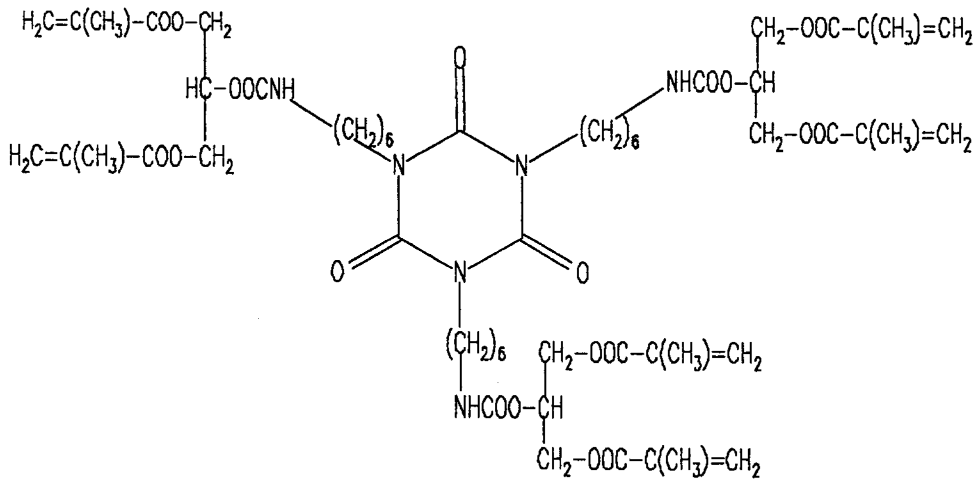

The magenta dye-donor element Mitsubishi CK100S was used as dye material.

The photosensitive recording material was laminated onto the dye material by means of a Type LPP650 device of Dorned BV (The Netherlands) comprising laminator rollers having a siliconized surface and a diameter of 60 mm. The lamination speed was 600 mm/min. The lamination was performed at 75 °C.

The side of the resulting laminate that showed the photosensitive recording material was exposed image-wise in an AGFA Type DL 2000 exposure device using a mercury vapour lamp.

The exposed recording material was peeled from the dye material. The recording material showed an adhering image-like dye pattern.

The recording material carrying the dye pattern was placed in face-to-face contact with a commercially available receptor material Mitsubishi CK100S having a paper support.

The contacting materials were overall heated by means of the above-mentioned laminator device to a temperature of 120 °C, the speed of progression of the contacting materials between the rollers being 600 mm/min. During the heating the dye diffused and migrated to the receptor material.

By means of a Macbeth TR 924 densitometer the difference between Dmin and Dmax (contrast density) was measured through a green filter on the receptor material carrying the transferred dye. The contrast difference measured was 0.25.

EXAMPLE 2

A photosensitive recording material was made as described in Example 1.

The cyan dye-donor element Mitsubishi CK100S was used as dye material.

The photosensitive recording material was laminated onto the dye material and the image-wise exposure was carried out as described in Example 1.

After the image-wise exposure the laminate was heated by means of the above-mentioned laminator device to a temperature of 90 °C, the speed of progression of the contacting materials between the rollers being 600 mm/min.

The recording material carrying a dye pattern was peeled from the dye material and placed in face-to-face contact with a receptor material as described in Example 1. The contacting materials were overall heated by means of the above-mentioned laminator device to a temperature of 120 °C, the speed of progression of the contacting materials between the rollers being 600 mm/min. During the heating the dye diffused and migrated to the receptor material.

By means of a Macbeth TR 924 densitometer the difference between Dmin and Dmax (contrast density) was measured through a red filter on the receptor material carrying the transferred dye. The contrast difference measured was 0.53.

EXAMPLE 3

Example 2 was repeated with the only difference that the recording material carrying the dye pattern was subjected to a uniform post-exposure (250 exposure units) in an AGFA Type DL 2000 exposure device using a mercury vapour lamp.

The contrast difference measured was 0.69.

EXAMPLE 4

Example 2 was repeated with the only difference that the dye-donor element used as dye material was made by coating one side of a polyethylene terephthalate support having a thickness of 6 µm with a dye layer (2.25 g/m2) comprising 1 g/m2 of copolystyrene-acrylonitrile and 0.05 g/m2 of polyethylene wax (Ceridust marketed by Hoechst) as binder, 0.8 g/m2 of the dye according to the formula:

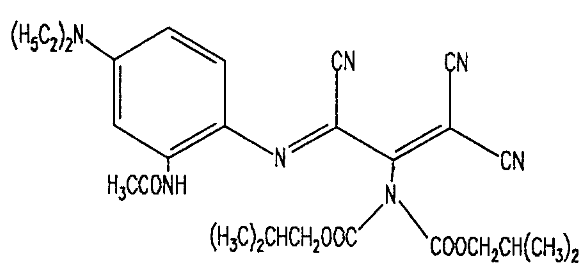

and 0.4 g/m2 of the dye according to the formula :

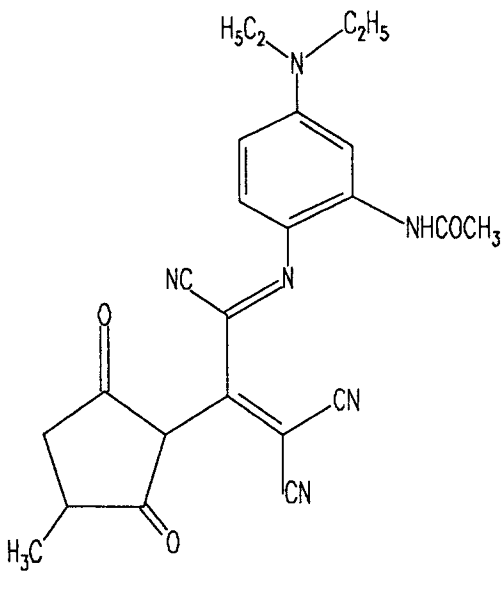

The contrast difference measured was 0.61.

EXAMPLE 5

Example 4 was repeated with the only difference that the recording material carrying the dye pattern was subjected to a uniform post-exposure (250 exposure units) in an AGFA Type DL 2000 exposure device using a mercury vapour lamp.

The contrast difference measured was 0.67.

## Claims

**1.** Method of making heat-transferred dye prints comprising the following consecutive steps :

- laminating a photosensitive recording material comprising a subbed transparent synthetic resin film support and a photopolymerizable layer onto a dye or dye precursor material comprising an unsubbed synthetic resin film support and a heat-transferable dye layer or heat-transferable dye precursor layer so as to bring the photopolymerizable layer in face-to-face contact with the heat-transferable dye or dye precursor layer and to cause the photopolymerizable layer to adhere to the heat-transferable dye or dye precursor layer,
- exposing the resulting laminate through the subbed transparent synthetic resin film support to image-wise modulated electromagnetic radiation, to which the photopolymerizable layer is sensitive, to bring about an image-like differentiation in adhesiveness of said photopolymerizable layer towards the adjacent heat-transferable dye or dye precursor layer,
- peeling said recording material from said dye or dye precursor material, heat-transferable dye or dye precursor being taken away thereby from said dye or dye precursor material and adhering to said recording material in correspondence with the created image-like differentiation in adhesiveness,
- bringing said recording material carrying a transferred dye or dye precursor pattern in face-to-face contact with a receptor material,
- overall heating at least one of the contacting recording material and receptor material to a temperature sufficiently high and for a sufficient time to allow at least part of the dye or dye precursor pattern to diffuse and transfer to said receptor material, and
- causing - in the case of said dye precursor - reaction of said dye precursor on the receptor material with a reagent present in said receptor material or in a fluid medium applied to said receptor material to convert said dye precursor into a dye.

**2.** A method according to claim 1, wherein the said resulting laminate is heated after the exposure to image-wise modulated electromagnetic radiation to enhance said image-like differentiation in adhesiveness.

3. A method according to claim 1 or 2, wherein said recording material carrying a transferred dye or dye precursor pattern prior to being brought in face-to-face contact with a receptor material is uniformly exposed to UV-radiation to enhance said image-like differentiation in adhesiveness.

4. A method according to any of claims 1 to 3, wherein the dye diffused and transferred to the receptor material is mordanted.

5. A method according to any of claims 1 to 4, wherein during said exposure to image-wise modulated electromagnetic radiation the adhesiveness of said photopolymerizable layer towards said adjacent heat-transferable dye or dye precursor layer is enhanced at the photopolymerized areas.

6. A method according to any of claims 1 to 4, wherein during said exposure to image-wise modulated electromagnetic radiation the adhesiveness of said photopolymerizable layer towards said adjacent heat-transferable dye or dye precursor layer is weakened at the photopolymerized areas.

European Patent Office

# EUROPEAN SEARCH REPORT

Application Number
EP 93 20 1538

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X,Y | EP-A-0 487 797 (TOYO INK MANUFACTURING CO., LTD.)<br>* claims 1-; example 2 *<br>* page 4, line 13 - line 14 *<br>* line 55 * | 1-6 | G03F7/34<br>G03F7/00<br>B41M5/035<br>G03F3/10 |
| Y | | 2 | |
| Y | | 4 | |
| Y | --- | 5,6 | |
| Y | FR-A-2 374 664 (SUBLISTATIC HOLDING S.A.)<br>* claims *<br>--- | 1-6 | |
| Y | FR-A-2 085 786 (CIBA-GEIGY AG)<br>* page 3, line 8 - line 23 *<br>--- | 4 | |
| Y | GB-A-851 384 (CHEMISCHE FABRIEK L. VAN DER GRINTEN)<br>* page 3, line 7 - line 26 *<br>--- | 5,6 | |
| Y | US-A-3 342 593 (M. BURG)<br>* claim 1; figure X *<br>--- | 2 | TECHNICAL FIELDS SEARCHED (Int.Cl.5) |
| A | GB-A-1 066 966 (AGFA AG.)<br>* page 3, line 106 - page 4, line 58; claim 4 *<br>----- | 1-6 | G03F<br>B41M |

The present search report has been drawn up for all claims

| Place of search | Date of completion of the search | Examiner |
|---|---|---|
| THE HAGUE | 17 November 1993 | RASSCHAERT, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)